# EUROPEAN PATENT APPLICATION

(11) **EP 4 636 482 A2**
(43) Date of publication of application: **22.10.2025**
(21) Application number: 25170798.0
(22) Date of filing: 15.04.2025
(51) Int. Cl.: G03F 7/00, G03F 7/004, G03F 7/038, G03F 7/075, G03F 7/095, G03F 7/105

(54) **MULTILAYER-STRUCTURE-TYPE PHOTOSENSITIVE DRY FILM, PATTERNING PROCESS, DISPLAY, AND MICRO-LED DISPLAY**

(30) Priority: 19.04.2024 JP 2024067923
(71) Applicant: Shin-Etsu Chemical Co., Ltd., Chiyoda-ku Tokyo 100-0005 (JP)
(72) Inventor: MARUYAMA, Hitoshi, Gunma (JP); KUMAZAWA, Kumiko, Gunma (JP)
(74) Representative: Schicker, Silvia

(57) **Abstract**

The present invention is a multilayer-structure-type photosensitive dry film including: a support film; a photosensitive resin film layer (A) having a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, and having a film thickness of 1 to 10 µm on the support film; and a photosensitive resin film layer (B) containing quantum dots and having a film thickness of 1 to 100 µm on the photosensitive resin film layer (A). This can provide: a material that makes it possible to perform a process for a photoresist containing quantum dots and a process for a resist material that absorbs blue LED light at once and not separately; a patterning process using the material; and a display including the material.

## Description

### TECHNICAL FIELD

The present invention relates to: a multilayer-structure-type photosensitive dry film; a patterning process; a display; and a micro-LED display.

### BACKGROUND ART

Various methods have been proposed to form displays containing red, green, and blue subpixels. As one of the methods, there is a method in which light from an LED array is converted through a color conversion structure such that blue light, having a shorter wavelength, is converted to red and green light, having longer wavelengths. Quantum dots have been employed for this color conversion.

Recently, such LED arrays are fabricated in micro size, and micro-LED displays using these have drawn attention. Although a method of forming a color conversion structure on an LED array includes a lithography process using a photosensitive material (Patent Document 1), there is a problem that, when transmittance at the exposure wavelength in the lithography process is ensured for forming the pattern, blue light that has not been color-converted by quantum dots and is transmitted appears on the outside when the light of a blue LED is applied to the cured film from below, and display clarity is degraded, since, generally, the absorbance of quantum dots is greater at the exposure wavelength in a lithography process than at the wavelength of blue LED light. To solve this problem, it is necessary to form, by employing a lithography process, a blue-light-absorption layer selectively, exclusively on subpixels in which a cured photoresist film containing quantum dots that emit red light is laminated on a blue LED and on subpixels in which a cured photoresist film containing quantum dots that emit green light is laminated on a blue LED. However, from the viewpoint of mass production, it is inefficient to perform separately a process for a photoresist containing quantum dots and a process for a resist material that absorbs blue LED light, and improvement is desired.

### CITATION LIST

### PATENT LITERATURE

Patent Document 1: JP 2021-089347 A

### SUMMARY OF INVENTION

### TECHNICAL PROBLEM

The present invention has been made in view of the above circumstances. An object of the present invention is to provide: a material that makes it possible to perform a process for a photoresist containing quantum dots and a process for a resist material that absorbs blue LED light at once and not separately; a patterning process using the material; and a display including the material.

### SOLUTION TO PROBLEM

To achieve the object, the present invention provides a multilayer-structure-type photosensitive dry film comprising:
a support film;
a photosensitive resin film layer (A) having a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, and having a film thickness of 1 to 10 µm on the support film; and
a photosensitive resin film layer (B) containing quantum dots and having a film thickness of 1 to 100 µm on the photosensitive resin film layer (A).

Such a photosensitive dry film is a material that makes it possible to perform a process for a photoresist containing quantum dots and a process for a resist material that absorbs blue LED light at once and not separately.

The photosensitive resin film layer (A) preferably contains 0.5 to 15 mass% of a dye having a maximum absorption wavelength at any wavelength of 490 to 430 nm.

When the content percentage of the dye is within this range, fine pattern formation is possible while a favorable property of absorbing blue LED light is retained.

The photosensitive resin film layer (B) preferably contains 15 to 45 mass% of the quantum dots.

When the content percentage of the quantum dot particles is within this range, fine pattern formation is possible while favorable luminous properties are retained.

It is preferable that the quantum dots each have a core-shell structure including a core and a shell covering the core, the core containing one or more compounds including a combination of two or more of In, P, Zn, Ga, Cd, Se, S, Te, Pb, Ag, Hg, N, As, and O, and the shell containing one or more compounds including a combination of two or more of In, P, Zn, Ga, Cd, Se, S, Te, Pb, Hg, N, As, O, Mn, and Sr.

In the present invention, such quantum dots can be used suitably.

It is preferable that one or both of the photosensitive resin film layer (A) and the photosensitive resin film layer (B) contain, as a resin component, an acrylic resin having a (meth)acryloyl group in a side chain.

Thus, it is possible to form a pattern that is fine and is excellent in verticality.

It is preferable that one or both of the photosensitive resin film layer (A) and the photosensitive resin film layer (B) contain, as a resin component, a resin having a silicone skeleton and a silphenylene skeleton.

Thus, it is possible to form a pattern that is fine and is excellent in verticality.

The present invention also provides a patterning process comprising the steps of:
(i) bonding a side of the photosensitive resin film layer (B) of the above-described multilayer-structure-type photosensitive dry film to a substrate to form a photosensitive resin film on the substrate;
(ii) exposing the photosensitive resin film to light; and
(iii) developing the exposed photosensitive resin film with a developer to dissolve and remove an unexposed portion to form a pattern.

By performing, using the inventive photosensitive dry film, a process for a photoresist containing quantum dots and a process for a resist material that absorbs blue LED light at once and not separately, a pattern having a desired shape can be formed.

The present invention also provides a display comprising a pattern formed of a cured film of the photosensitive resin film layer (A) and the photosensitive resin film layer (B) of the above-described multilayer-structure-type photosensitive dry film.

The inventive multilayer-structure-type photosensitive dry film can be used particularly suitably for such a purpose.

The present invention also provides a display comprising, in a top portion of a blue LED, a pattern formed of a cured film of the photosensitive resin film layer (A) and the photosensitive resin film layer (B) of the above-described multilayer-structure-type photosensitive dry film, light color-converted by quantum dots being obtained from each subpixel.

The inventive multilayer-structure-type photosensitive dry film can be used particularly suitably for such a purpose.

The present invention also provides a micro-LED display comprising, in a top portion of a blue LED, a pattern formed of a cured film of the photosensitive resin film layer (A) and the photosensitive resin film layer (B) of the above-described multilayer-structure-type photosensitive dry film, the pattern formed of the cured film having a size of 0.01 mm² or less, and light color-converted by quantum dots being obtained from each subpixel.

The inventive multilayer-structure-type photosensitive dry film can be used particularly suitably for such a purpose.

### ADVANTAGEOUS EFFECTS OF INVENTION

The inventive multilayer-structure-type photosensitive dry film makes it possible to perform a process for a photoresist containing quantum dots and a process for a resist material that absorbs blue LED light at once and not separately. In addition, the inventive patterning process makes it possible easily to form a pattern that is fine and is excellent in verticality. In addition, an obtained cured film allows favorable hue conversion of blue LED light, and therefore, can be used suitably for displays such as micro-LED displays.

### BRIEF DESCRIPTION OF DRAWINGS

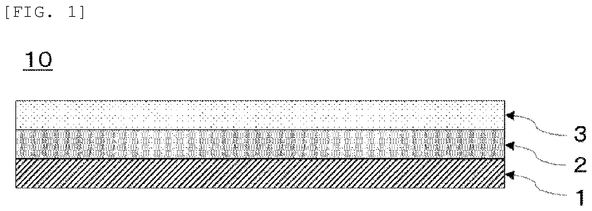

FIG. 1 is a schematic view showing an example of the inventive multilayer-structure-type photosensitive dry film.

### DESCRIPTION OF EMBODIMENTS

As stated above, there have been demands for the development of: a material that makes it possible to perform a process for a photoresist containing quantum dots and a process for a resist material that absorbs blue LED light at once and not separately; a patterning process using the material; and a display including the material.

The present inventors have earnestly studied and found out that by combining, as a single dry film, a photoresist containing quantum dots and a resist material that absorbs blue LED light, a process does not have to be performed separately and can be performed at once, and completed the present invention. When such a dry film is used, it is not necessary to perform a process again, and improvement in productivity can be expected.

That is, the present invention is a multilayer-structure-type photosensitive dry film comprising:
a support film;
a photosensitive resin film layer (A) having a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, and having a film thickness of 1 to 10 µm on the support film; and
a photosensitive resin film layer (B) containing quantum dots and having a film thickness of 1 to 100 µm on the photosensitive resin film layer (A).

Hereinafter, the present invention will be described in detail, but the present invention is not limited thereto.

### [Photosensitive Resin Film Layer (A)]

The photosensitive resin film layer (A) used in the present invention is not particularly limited as long as it is a photosensitive resin film layer having a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, and having a film thickness of 1 to 10 µm. When the transmittance and the film thickness are as described, blue LED light can be eliminated selectively, and excellent process aptitude can be achieved.

The photosensitive resin film layer (A) can be, for example, a photosensitive resin film layer having a transmittance of 2% or less in a wavelength of 450 to 470 nm, a transmittance of 80% or more in a wavelength of 515 to 535 nm, and a transmittance of 80% or more in a wavelength of 620 to 640 nm, and having a film thickness of 1 to 10 µm.

In the present invention, the photosensitive resin film layer (A) preferably contains 0.5 to 15 mass%, more preferably 1 to 10 mass% of a dye having a maximum absorption wavelength at any wavelength of 490 to 430 nm. When the content percentage of the dye is within these ranges, fine pattern formation is possible while a favorable property of absorbing blue LED light is retained.

The maximum absorption wavelength is determined in the following manner. Firstly, employing UV-vis (ultraviolet-visible) absorption spectroscopy, a sample is irradiated with ultraviolet rays or visible light, and in this event, while continuously scanning the irradiation wavelength, the quantity of light absorbed by the sample (absorbance) is measured. The measurement results are obtained as a graph (absorption spectrum) in which the wavelength is plotted on the horizontal axis and the absorbance is plotted on the vertical axis, and the wavelength at which the spectrum has the maximum value is defined as the maximum absorption wavelength.

As such a dye, a commercially available product can be used, and examples include FDB-002 (maximum absorption wavelength: 431 nm), FDB-003 (maximum absorption wavelength: 438 nm), FDB-004 (maximum absorption wavelength: 445 nm), FDB-005 (maximum absorption wavelength: 452 nm), and FDB-006 (maximum absorption wavelength: 473 nm) manufactured by Yamada Chemical Co., Ltd., FS Yellow 1017 (maximum absorption wavelength: 443 nm) manufactured by ARIMOTO CHEMICAL Co., Ltd., and Dye3 (maximum absorption wavelength: 464 nm) and Dye4 (maximum absorption wavelength: 479 nm) manufactured by Hayashibara Co., Ltd.

In the present invention, the photosensitive resin film layer (A) preferably contains an acrylic resin having a (meth)acryloyl group in a side chain or a resin having a silicone skeleton and a silphenylene skeleton. Thus, it is possible to form a pattern that is fine and is excellent in verticality.

One kind of such a resin may be used, or two or more kinds thereof may be used in combination, and the resin is preferably 40 to 99 mass% in the layer (A), further preferably 50 to 98 mass%.

As the acrylic resin having a (meth)acryloyl group in a side chain, one in which Mw is 5000 to 500000 is favorable, and a commercially available product can be used. Examples thereof include "RA-4101" (trade name) (Mw: 30,000, acid value: 90 mg KOH/g, double bond equivalent: 350 g/mol) manufactured by Negami Chemical Industrial Co., Ltd. and "8KQ-2001" (trade name) (Mw: 20,000, acid value: 130 mg KOH/g, double bond equivalent: 540 g/mol) manufactured by Taisei Fine Chemical Co., Ltd.

Note that, in the present description, the weight-average molecular weight Mw is a value determined as a weight-average molecular weight (weight-average degree of polymerization) in terms of polystyrene measured by GPC (gel permeation chromatography) analysis using toluene as an eluent.

As the resin having a silicone skeleton and a silphenylene skeleton, one in which Mw is 3000 to 500000 is favorable, and examples include resins containing repeating units represented by the following formulae (A1) to (A6).

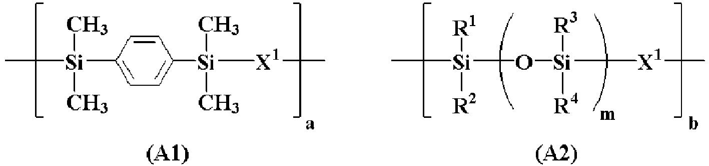

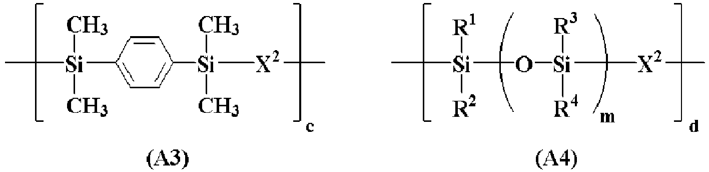

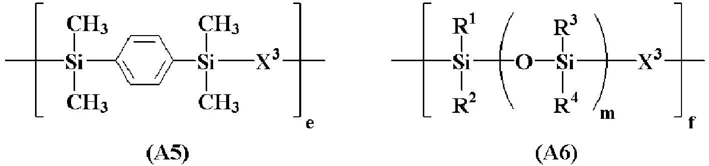

In the formulae, R¹ to R⁴ each independently represent a monovalent hydrocarbon group having 1 to 20 carbon atoms and optionally containing a heteroatom. Each "m" independently represents an integer of 1 to 600. When "m" is an integer of 2 or more, the R³s may be identical to or different from each other, and the R⁴s may be identical to or different from each other. "a", "b", "c", "d", "e", and "f" represent numbers that satisfy 0 ≤ a ≤ 1, 0 ≤ b ≤ 1, 0 ≤ c ≤ 1, 0 ≤ d ≤ 1, 0 ≤ e ≤ 1, 0 ≤ f ≤ 1, 0 < c+d+e+f ≤ 1, and a+b+c+d+e+f = 1. X¹ represents a divalent group represented by the following formula (X1). X² represents a divalent group represented by the following formula (X2). X³ represents a divalent group represented by the following formula (X3).

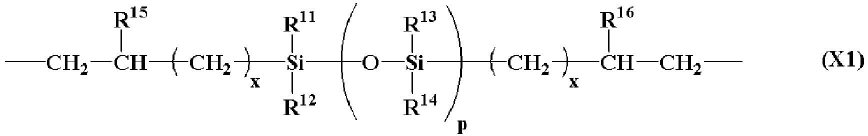

In the formula, R¹¹ to R¹⁴ each independently represent a monovalent hydrocarbon group having 1 to 20 carbon atoms and optionally containing a heteroatom. "p" represents an integer of 1 to 600. When "p" is an integer of 2 or more, the R¹³s may be identical to or different from each other, and the R¹⁴s may be identical to or different from each other. R¹⁵ and R¹⁶ each independently represent a hydrogen atom or a methyl group. Each "x" independently represents an integer of 0 to 7.

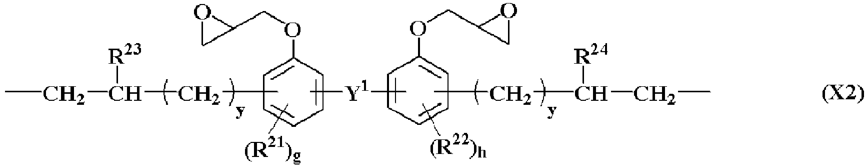

In the formula, Y¹ represents a single bond, a methylene group, a propane-2,2-diyl group, a 1,1,1,3,3,3-hexafluoropropane-2,2-diyl group, or a fluorene-9,9-diyl group. R²¹ and R²² each independently represent an alkyl group or alkoxy group having 1 to 4 carbon atoms, and "g" and "h" each independently represent 0, 1, or 2. When "g" is 2, the R²¹s may be identical to or different from each other, and when "h" is 2, the R²²s may be identical to or different from each other. R²³ and R²⁴ each independently represent a hydrogen atom or a methyl group. Each "y" independently represents an integer of 0 to 7.

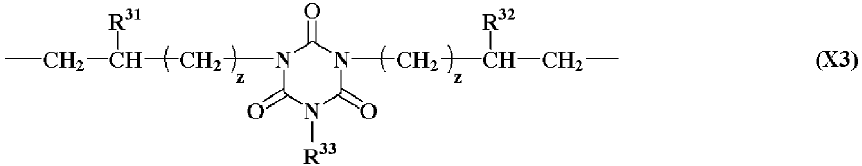

In the formula, R³¹ and R³² each independently represent a hydrogen atom or a methyl group. Each "z" independently represents an integer of 0 to 7. R³³ represents a monovalent hydrocarbon group having 1 to 8 carbon atoms and optionally containing an ester bond or an ether bond, or represents a monovalent group represented by the following formula (X3-1).

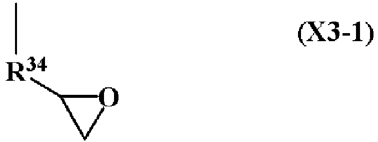

In the formula, R³⁴ represents a divalent hydrocarbon group having 1 to 8 carbon atoms and optionally containing an ester bond or an ether bond.

In the present invention, the photosensitive resin film layer (A) preferably contains a photopolymerization initiator for photo-curing. In particular, a photo-radical generator or a photo-acid generator is preferably contained. Furthermore, the photopolymerization initiator is preferably contained in an amount of 0.1 to 10 mass%, more preferably 0.5 to 7 mass% based on the photosensitive resin film layer (A). When the content percentage of the photopolymerization initiator is in the above-described ranges, favorable pattern formation can be performed.

The photosensitive resin film layer (A) can be manufactured, for example, by the following method. Firstly, a photosensitive resin composition (A), in which the above-described components of the photosensitive resin film layer (A) have been dissolved or dispersed in a solvent, is prepared.

In this event, the solvent is preferably an organic solvent. Examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone; etc. One of these may be used, or two or more thereof may be used in mixture.

The solvent is preferably contained in an amount of 25 to 85 mass%, more preferably 35 to 75 mass% based on the total amount from the viewpoints of compatibility and viscosity of the above-described components of the photosensitive resin film layer (A).

The photosensitive resin composition (A) can be applied to a support film and dried to form a photosensitive resin film layer (A). As the production apparatus, it is possible to employ a film coater which is commonly used to produce adhesive products. Examples of the film coater include a comma coater, a comma reverse coater, a multi coater, a die coater, a lip coater, a lip reverse coater, a direct gravure coater, an offset gravure coater, a 3-roll bottom reverse coater, a 4-roll bottom reverse coater, etc.

When the support film is rolled out from a roll-out shaft of the film coater and passes through a coater head of the film coater, the dissolved or dispersed solution (photosensitive resin composition (A)) is applied to have a predetermined thickness onto the support film; then, the resultant is passed through a hot-air circulating oven at a predetermined temperature for a predetermined period to dry and form the photosensitive resin film on the support film, so that the photosensitive resin film layer (A) can be produced. It is also possible to produce the photosensitive resin film layer (A) having a protective film in accordance with need by: passing the photosensitive resin film layer through a laminate roll under a predetermined pressure together with the protective film that has been rolled out from another roll-out shaft of the film coater, thereby bonding the protective film to the photosensitive resin film on the support film; and subsequently winding up the resulting laminate to a winding shaft of the film coater. In this case, the temperature is preferably 50 to 120°C, the period is preferably 1 to 100 minutes, and the pressure is preferably 0.01 to 5 MPa.

The support film used in the photosensitive resin film layer (A) may be a monolayer film composed of a single film or a multilayer film composed of multiple laminated films. Examples of the material of the film include synthetic resin films, such as polyethylene, polypropylene, polycarbonate, and polyethylene terephthalate. Among these, preferable is polyethylene terephthalate having appropriate flexibility, mechanical strength, and heat resistance. These films may have been subjected to various treatments, such as corona treatment and coating treatment with a releasing agent. Commercial products may be used for these. Examples thereof include Cerapeel WZ (RX) and Cerapeel BX8 (R) (both manufactured by Toray Advanced Film Co., Ltd.), E7302 and E7304 (both manufactured by Toyobo Co., Ltd.), Purex G31 and Purex G71T1 (both manufactured by Teijin DuPont Films Japan Ltd.), PET38×1-A3, PET38×1-V8, and PET38×1-X08 (all manufactured by Nippa Co., Ltd.), etc.

The protective film to be used may be the same film as the above-mentioned support film, but polyethylene terephthalate and polyethylene having appropriate flexibility are preferred. Commercial products may be used for these. Examples thereof include the polyethylene terephthalates that have already been exemplified; polyethylenes, such as GF-8 (manufactured by Tamapoly Co., Ltd.) and PE Film 0-Type (manufactured by Nippa Co., Ltd.); etc.

The thicknesses of both the support film and the protective film are preferably 10 to 100 µm, more preferably 25 to 50 µm, from the viewpoints of stable production of the photosensitive dry film and the rolling habit around a roll shaft, what is called curl-prevention.

### [Photosensitive Resin Film Layer (B)]

The photosensitive resin film layer (B) used in the present invention is not particularly limited as long as it is a photosensitive resin film layer containing quantum dots and having a film thickness of 1 to 100 µm. When the film thickness is as described, excellent process aptitude can be achieved.

In the present invention, the photosensitive resin film layer (B) preferably contains 15 to 45 mass%, more preferably 20 to 40 mass% of the quantum dots. When the content percentage of the quantum dot particles is within this range, fine pattern formation is possible while favorable luminous properties are retained.

The quantum dots in the photosensitive resin film layer (B) of the present invention preferably each have a core-shell structure including a core and a shell covering the core, and it is preferable that the core contains one or more compounds including a combination of two or more of In, P, Zn, Ga, Cd, Se, S, Te, Pb, Ag, Hg, N, As, and O, and the shell contains one or more compounds including a combination of two or more of In, P, Zn, Ga, Cd, Se, S, Te, Pb, Hg, N, As, O, Mn, and Sr. Preferable examples of such combinations include fine particles in which the core is InP or AgGaSe, and the shell is ZnS, ZnSe, or ZnSeS. Preferable core-shell combinations include core/shell = InP/ZnS, InP/ZnSe, InP/ZnSeS, and AgGaSe/ZnS.

As the quantum dots, it is preferable to use particles having a particle size of 1 to 10 nm. Incidentally, the particle size of the quantum dots can be, for example, a value determined by dynamic light scattering by using ELSZ-2000ZS, manufactured by Otsuka Electronics Co., Ltd.

As such quantum dots, a commercially available product can be used, and examples include S-BE030 (InP (core) /ZnS and ZnSe (shell), maximum fluorescence wavelength: 635 nm) and S-BE029 (InP (core) /ZnS and ZnSe (shell), maximum fluorescence wavelength: 535 nm) manufactured by SHOEI CHEMICAL INC., 900514-1ML (CdSe (core) /CdS (shell), maximum fluorescence wavelength: 620 nm) manufactured by Aldrich, and 900511-1ML (CdSe (core) /CdS (shell), maximum fluorescence wavelength: 530 nm) manufactured by Aldrich.

In the present invention, the photosensitive resin film layer (B) preferably contains an acrylic resin having a (meth)acryloyl group in a side chain or a resin having a silicone skeleton and a silphenylene skeleton. Thus, it is possible to form a pattern that is fine and is excellent in verticality.

One kind of such a resin may be used, or two or more kinds thereof may be used in combination, and the resin is preferably 10 to 85 mass% in the layer (B), further preferably 20 to 80 mass%.

As the acrylic resin having a (meth)acryloyl group in a side chain, one in which Mw is 5000 to 500000 is favorable, and a commercially available product can be used. Examples thereof include "RA-4101" (trade name) (Mw: 30,000, acid value: 90 mg KOH/g, double bond equivalent: 350 g/mol) manufactured by Negami Chemical Industrial Co., Ltd. and "8KQ-2001" (trade name) (Mw: 20,000, acid value: 130 mg KOH/g, double bond equivalent: 540 g/mol) manufactured by Taisei Fine Chemical Co., Ltd.

As the resin having a silicone skeleton and a silphenylene skeleton, one in which Mw is 3000 to 500000 is favorable, and examples include resins containing repeating units represented by the following formulae (A1) to (A6).

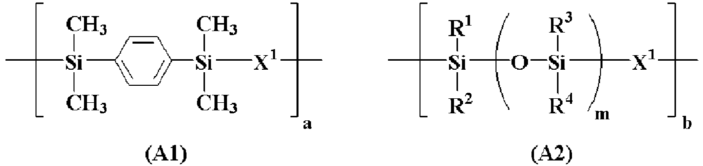

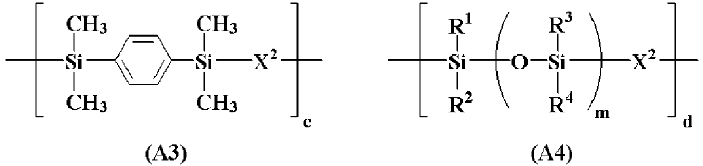

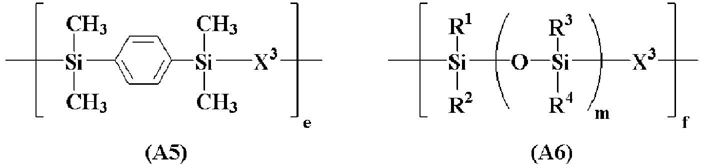

In the formulae, R¹ to R⁴ each independently represent a monovalent hydrocarbon group having 1 to 20 carbon atoms and optionally containing a heteroatom. Each "m" independently represents an integer of 1 to 600. When "m" is an integer of 2 or more, the R³s may be identical to or different from each other, and the R⁴s may be identical to or different from each other. "a", "b", "c", "d", "e", and "f" represent numbers that satisfy 0 ≤ a ≤ 1, 0 ≤ b ≤ 1, 0 ≤ c ≤ 1, 0 ≤ d ≤ 1, 0 ≤ e ≤ 1, 0 ≤ f ≤ 1, 0 < c+d+e+f ≤ 1, and a+b+c+d+e+f = 1. X¹ represents a divalent group represented by the following formula (X1). X² represents a divalent group represented by the following formula (X2). X³ represents a divalent group represented by the following formula (X3).

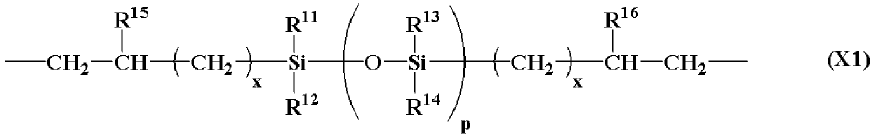

In the formula, R¹¹ to R¹⁴ each independently represent a monovalent hydrocarbon group having 1 to 20 carbon atoms and optionally containing a heteroatom. "p" represents an integer of 1 to 600. When "p" is an integer of 2 or more, the R¹³s may be identical to or different from each other, and the R¹⁴s may be identical to or different from each other. R¹⁵ and R¹⁶ each independently represent a hydrogen atom or a methyl group. Each "x" independently represents an integer of 0 to 7.

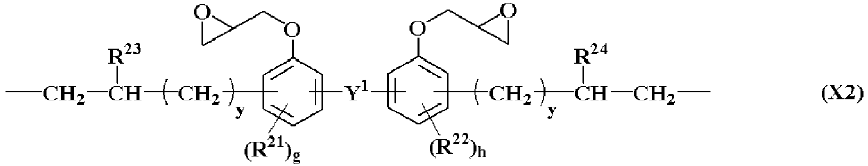

In the formula, Y¹ represents a single bond, a methylene group, a propane-2,2-diyl group, a 1,1,1,3,3,3-hexafluoropropane-2,2-diyl group, or a fluorene-9,9-diyl group. R²¹ and R²² each independently represent an alkyl group or alkoxy group having 1 to 4 carbon atoms, and "g" and "h" each independently represent 0, 1, or 2. When "g" is 2, the R²¹s may be identical to or different from each other, and when "h" is 2, the R²²s may be identical to or different from each other. R²³ and R²⁴ each independently represent a hydrogen atom or a methyl group. Each "y" independently represents an integer of 0 to 7.

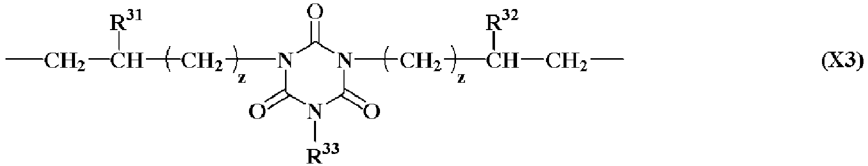

In the formula, R³¹ and R³² each independently represent a hydrogen atom or a methyl group. Each "z" independently represents an integer of 0 to 7. R³³ represents a monovalent hydrocarbon group having 1 to 8 carbon atoms and optionally containing an ester bond or an ether bond, or represents a monovalent group represented by the following formula (X3-1).

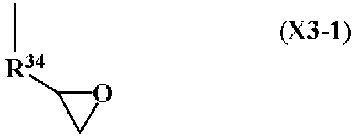

In the formula, R³⁴ represents a divalent hydrocarbon group having 1 to 8 carbon atoms and optionally containing an ester bond or an ether bond.

In the present invention, the photosensitive resin film layer (B) preferably contains a photopolymerization initiator for photo-curing. In particular, a photo-radical generator or a photo-acid generator is preferably contained. Furthermore, the photopolymerization initiator is preferably contained in an amount of 0.1 to 10 mass%, more preferably 0.5 to 7 mass% based on the photosensitive resin film layer (B). When the content percentage of the photopolymerization initiator is in the above-described ranges, favorable pattern formation can be performed.

The photosensitive resin film layer (B) can be manufactured, for example, by the following method. Firstly, a photosensitive resin composition (B), in which the above-described components of the photosensitive resin film layer (B) have been dissolved or dispersed in a solvent, is prepared.

In this event, the solvent is preferably an organic solvent. Examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone; etc. One of these may be used, or two or more thereof may be used in mixture.

The solvent is preferably contained in an amount of 25 to 85 mass%, more preferably 35 to 75 mass% based on the total amount from the viewpoints of compatibility and viscosity of the above-described components of the photosensitive resin film layer (B).

The photosensitive resin composition (B) can be applied to a support film and dried to form a photosensitive resin film layer (B). As the production apparatus, it is possible to employ a film coater which is commonly used to produce adhesive products. Examples of the film coater include a comma coater, a comma reverse coater, a multi coater, a die coater, a lip coater, a lip reverse coater, a direct gravure coater, an offset gravure coater, a 3-roll bottom reverse coater, a 4-roll bottom reverse coater, etc.

When the support film is rolled out from a roll-out shaft of the film coater and passes through a coater head of the film coater, the dissolved or dispersed solution (photosensitive resin composition (B)) is applied to have a predetermined thickness onto the support film; then, the resultant is passed through a hot-air circulating oven at a predetermined temperature for a predetermined period to dry and form the photosensitive resin film on the support film, so that the photosensitive resin film layer (B) can be produced. It is also possible to produce the photosensitive resin film layer (B) having a protective film in accordance with need by: passing the photosensitive resin film layer through a laminate roll under a predetermined pressure together with the protective film that has been rolled out from another roll-out shaft of the film coater, thereby bonding the protective film to the photosensitive resin film on the support film; and subsequently winding up the resulting laminate to a winding shaft of the film coater. In this case, the temperature is preferably 50 to 120°C, the period is preferably 1 to 100 minutes, and the pressure is preferably 0.01 to 5 MPa.

The support film used in the photosensitive resin film layer (B) may be a monolayer film composed of a single film or a multilayer film composed of multiple laminated films. Examples of the material of the film include synthetic resin films, such as polyethylene, polypropylene, polycarbonate, and polyethylene terephthalate. Among these, preferable is polyethylene terephthalate having appropriate flexibility, mechanical strength, and heat resistance. These films may have been subjected to various treatments, such as corona treatment and coating treatment with a releasing agent. Commercial products may be used for these. Examples thereof include Cerapeel WZ (RX) and Cerapeel BX8 (R) (both manufactured by Toray Advanced Film Co., Ltd.), E7302 and E7304 (both manufactured by Toyobo Co., Ltd.), Purex G31 and Purex G71T1 (both manufactured by Teijin DuPont Films Japan Ltd.), PET38×1-A3, PET38×1-V8, and PET38×1-X08 (all manufactured by Nippa Co., Ltd.), etc.

The protective film to be used may be the same film as the above-mentioned support film, but polyethylene terephthalate and polyethylene having appropriate flexibility are preferred. Commercial products may be used for these. Examples thereof include the polyethylene terephthalates that have already been exemplified; polyethylenes, such as GF-8 (manufactured by Tamapoly Co., Ltd.) and PE Film 0-Type (manufactured by Nippa Co., Ltd.); etc.

The thicknesses of both the support film and the protective film are preferably 10 to 100 µm, more preferably 25 to 50 µm, from the viewpoints of stable production of the photosensitive dry film and the rolling habit around a roll shaft, what is called curl-prevention.

### [Multilayer-Structure-Type Photosensitive Dry Film]

As shown in FIG. 1, the inventive multilayer-structure-type photosensitive dry film 10 includes: a support film 1; a photosensitive resin film layer (A) 2 having a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, and having a film thickness of 1 to 10 µm on the support film 1; and a photosensitive resin film layer (B) 3 containing quantum dots and having a film thickness of 1 to 100 µm on the photosensitive resin film layer (A) 2.

The multilayer-structure-type photosensitive dry film (support film and photosensitive resin film layers (A) and (B)) is solid, and the photosensitive resin film layers (A) and (B) do not contain a solvent. Accordingly, bubbles due to the volatilization of the solvent will not remain in the photosensitive resin film layers (A) and (B) and between the film and an uneven substrate.

In addition, at a high temperature, the viscosity and fluidity of the photosensitive resin film layers (A) and (B) are closely related. The photosensitive resin film layers (A) and (B) can exhibit appropriate fluidity in an appropriate viscosity range; the photosensitive resin film layers (A) and (B) deeply enter into a narrow gap and the resin softens, so that the adhesion to a substrate can be enhanced. Thus, the viscosity of the photosensitive resin film at a high temperature is preferably 10 to 5,000 Pa·s, more preferably 30 to 2,000 Pa·s at 80°C from the viewpoint of the fluidity of the photosensitive resin film layers (A) and (B). Note that, in the present invention, the viscosity is a value measured with a rotational viscometer.

When the inventive multilayer-structure-type photosensitive dry film is brought into close contact with an uneven substrate, the photosensitive resin film layers (A) and (B) fit in and cover the unevenness, so that high flatness can be achieved. Particularly, the photosensitive resin film layers (A) and (B) of the present invention have softening performance, so that higher planarization can be achieved. Further, bringing the photosensitive resin film into close contact with the substrate under vacuum environment makes it possible to more effectively prevent a gap therebetween.

As a method for manufacturing the multilayer-structure-type photosensitive dry film, there is, for example, a method of peeling off the protective film of each of the resist film material prepared above having the photosensitive resin film layer (A) and the protective film formed on the support film, and the resist film material prepared above having the photosensitive resin film layer (B) and the protective film formed on the support film, and pressing with a roll to roll film laminator. In this event, the roll temperature is preferably 10 to 120°C, and the pressure of the bonding roll is preferably 0 to 5.0 MPa.

Examples of other methods for manufacturing the multilayer-structure-type photosensitive dry film include a method including: applying the photosensitive resin composition (A) to have a predetermined thickness onto the support film when the support film is rolled out from a roll-out shaft of the film coater and passes through a coater head of the film coater; passing the resultant through a hot-air circulating oven at a predetermined temperature for a predetermined period to dry the composition on the support film; then further applying the photosensitive resin composition (B) to have a predetermined thickness and passing the resultant through a hot-air circulating oven at a predetermined temperature for a predetermined period to dry the composition on the support film; passing the resulting laminate through a laminate roll under a predetermined pressure together with the protective film that has been rolled out from another roll-out shaft of the film coater, thereby bonding the protective film to the resin layer on the support film; and subsequently winding up the resulting laminate to a winding shaft of the film coater. Incidentally, the order of the application may be reversed.

### [Patterning Process Using Multilayer-Structure-Type Photosensitive Dry Film]

A patterning process using the inventive multilayer-structure-type photosensitive dry film includes the steps of:
(i) bonding a side of the photosensitive resin film layer (B) of the multilayer-structure-type photosensitive dry film to a substrate to form a photosensitive resin film on the substrate;
(ii) exposing the photosensitive resin film to light; and
(iii) developing the exposed photosensitive resin film with a developer to dissolve and remove an unexposed portion to form a pattern.

First, (i) the multilayer-structure-type photosensitive dry film is used to bond the side of the photosensitive resin film (B) to a substrate to form the photosensitive resin films (A) and (B) on the substrate. Meanwhile, in the case where the multilayer-structure-type photosensitive dry film has a protective film, after the protective film is peeled from the multilayer-structure-type photosensitive dry film, the photosensitive resin film (B) side of the multilayer-structure-type photosensitive dry film is bonded to the substrate. The bonding can be performed, for example, by using a film-bonding apparatus.

The film-bonding apparatus is preferably a vacuum laminator. For example, the protective film of the multilayer-structure-type photosensitive dry film is delaminated, and the uncovered photosensitive resin film (B) is brought into close contact with the substrate on a table at a predetermined temperature by using a bonding roll under a predetermined pressure in a vacuum chamber with a predetermined degree of vacuum. It is to be noted that the temperature is preferably 60 to 120°C, the pressure is preferably 0 to 5.0 MPa, and the degree of vacuum is preferably 50 to 500 Pa.

For efficient photo-curing reaction of the photosensitive resin films (A) and (B) and for adhesiveness enhancement between the photosensitive resin film (B) and the substrate, pre-baking may be performed as necessary. The pre-baking can be performed, for example, at 60 to 120°C for about 1 minute to 1 hour.

The photosensitive resin films (A) and (B) adhered on the substrate can be subjected to (ii) the step of exposing the photosensitive resin film to light, and (iii) the step of developing the exposed photosensitive resin film with a developer to dissolve and remove an unexposed portion for patterning to form a pattern. Note that the support film of the multilayer-structure-type photosensitive dry film is delaminated before the development step, depending on the process.

In the step (ii), the photosensitive resin films (A) and (B) are exposed to light. In this event, the exposure is preferably performed with light having a wavelength of 10 to 600 nm, more preferably performed with light having a wavelength of 190 to 500 nm. The light having such wavelengths are, for example, light having various wavelengths generated from a radiation-beam generating instrument. Examples of the light include ultraviolet light, such as a g-line, an h-line, and an i-line; far ultraviolet light (248 nm, 193 nm); etc. Among these, light with a wavelength of 248 to 436 nm is particularly preferable. The exposure dose is preferably 10 to 10,000 mJ/cm².

The exposure may be performed via a photomask. The photomask may have a desired pattern by boring, for example. Note that the material of the photomask is not particularly limited, but is preferably one that blocks light with the aforementioned wavelength. For example, a photomask including a light-blocking film made of chromium is suitably used, but is not limited thereto.

In the step (iii), after the exposure, development is performed with a developer to form a pattern. Preferable examples of the developer include organic solvents such as: alcohols, such as IPA; ketones, such as cyclohexanone; glycols, such as propylene glycol monomethyl ether; etc. Examples of the development method include usual methods, for example, a dipping method in which the patterned substrate is soaked into the developer; a puddle method in which the developer is dispensed by puddle; and a spraying method in which the developer is applied by spraying. By performing the development in this manner, the unexposed portion is dissolved and removed, so that a pattern is formed. Then, if necessary, washing, rinsing, drying, and so forth are carried out to give a cured film having a desired pattern.

The patterning process using the inventive multilayer-structure-type photosensitive dry film makes it possible to easily form fine patterns. For example, it is possible to bond the inventive multilayer-structure-type photosensitive dry film to cover numerous blue micro-LEDs laid over a substrate, followed by fine pattern formation such that the cured film including the quantum dots of red, green, etc. is formed at corresponding sections on the blue micro-LEDs. This enables light emission of red, green, etc., and furthermore, makes it possible to absorb, by a cured film formed thereon having a predetermined light transmittance, blue LED light that has been transmitted. Thus, it is possible to produce efficiently a full-color display without the need to obtain the photosensitive resin film (A) and the photosensitive resin film (B) in separate processes. This case is also applicable to mini-LEDs.

### [Display]

The present invention also provides a display including a pattern formed of a cured film of the photosensitive resin film layer (A) and the photosensitive resin film layer (B) of the above-described multilayer-structure-type photosensitive dry film. A pattern formed of the cured film can be obtained by the above-described patterning process.

The inventive display can also be a display including, in a top portion of a blue LED, a pattern formed of a cured film of the photosensitive resin film layer (A) and the photosensitive resin film layer (B) of the above-described multilayer-structure-type photosensitive dry film, light color-converted by quantum dots being obtained from each subpixel.

### [Micro-LED Display]

The present invention also provides a micro-LED display including, in a top portion of a blue LED, a pattern formed of a cured film of the photosensitive resin film layer (A) and the photosensitive resin film layer (B) of the above-described multilayer-structure-type photosensitive dry film, the pattern formed of the cured film having a size of 0.01 mm² or less, and light color-converted by quantum dots being obtained from each subpixel.

### EXAMPLES

Hereinafter, the present invention will be specifically described with reference to Examples and Comparative Examples. However, the present invention is not limited to the Examples.

### [1] Preparation of Photosensitive Resin Compositions (A) and (B)

### [Preparation Examples A1 to A8, A'1 to A'3, BR1 to BR8, and BG1 to BG8]

Each component was blended according to the formulation amount shown in Tables 1 to 7, then, the components were stirred and mixed at normal temperature, and micro-filtering was performed with a 1.0-µm glass filter to obtain photosensitive resin compositions (solutions in PGMEA) of Preparation Examples A1 to A8, A'1 to A'3, BR1 to BR8, and BG1 to BG8. Note that, in the tables, the amounts are shown in such a manner that the total amount of the solid contents (components other than the solvent) is 100.

**[Table 1]**

| | | Preparation Example | | | |
|---|---|---|---|---|---|
| | | A1 | A2 | A3 | A4 |
| Resin | A-1 | 82.8 | 91.8 | | |
| | A-2 | | | 97.8 | 96.3 |
| Dye | B-1 | 10 | | | |
| | B-2 | | 5 | | |
| | B-3 | | | 1 | |
| | B-4 | | | | 3 |
| Photo-radical generator | C-1 | 7 | 3 | 1 | 0.5 |
| Surfactant | D-1 | 0.2 | 0.2 | 0.2 | 0.2 |
| Solvent | PGMEA | 100 | 100 | 100 | 100 |

**[Table 2]**

| | | Preparation Example | | | |
|---|---|---|---|---|---|
| | | A5 | A6 | A7 | A8 |
| Resin | A-3 | 83.0 | 73.6 | 98.0 | 77.2 |
| Dye | B-1 | 10 | | | |
| | B-2 | | 5 | | |
| | B-3 | | | 1 | |
| | B-4 | | | | 3 |
| Photo-acid generator | F-1 | 7 | 3 | 1 | 0.5 |
| Epoxy crosslinking agent | G-1 | | 18.4 | | 19.3 |
| Solvent | PGMEA | 100 | 100 | 100 | 100 |

**[Table 3]**

| | | Preparation Example | | | |
|---|---|---|---|---|---|
| | | BR1 | BR2 | BR3 | BR4 |
| Resin | A-1 | 72.8 | 76.8 | | |
| | A-2 | | | 58.8 | 59.3 |
| Quantum dots | BR-1 | 20 | | 40 | |
| | BR- 2 | | 20 | | 40 |
| Photo-radical generator | C-1 | 7 | 3 | 1 | 0.5 |
| Surfactant | D-1 | 0.2 | 0.2 | 0.2 | 0.2 |
| Solvent | PGMEA | 100 | 100 | 100 | 100 |

**[Table 4]**

| | | Preparation Example | | | |
|---|---|---|---|---|---|
| | | BR5 | BR6 | BR7 | BR8 |
| Resin | A-3 | 73.0 | 61.6 | 59. 0 | 47.6 |
| Quantum dots | BR-1 | 20 | | 40 | |
| | BR-2 | | 20 | | 40 |
| Photo-acid generator | F-1 | 7 | 3 | 1 | 0.5 |
| Epoxy crosslinking agent | G-1 | | 15.4 | | 11.9 |
| Solvent | PGMEA | 100 | 100 | 100 | 100 |

**[Table 5]**

| | | Preparation Example | | | |
|---|---|---|---|---|---|
| | | BG1 | BG2 | BG3 | BG4 |
| Resin | A-1 | 72.8 | 76.8 | | |
| | A-2 | | | 58.8 | 59.3 |
| Quantum dots | BG-1 | 20 | | 40 | |
| | BG-2 | | 20 | | 40 |
| Photo-radical generator | C-1 | 7 | 3 | 1 | 0.5 |
| Surfactant | D-1 | 0.2 | 0.2 | 0.2 | 0.2 |
| Solvent | PGMEA | 100 | 100 | 100 | 100 |

**[Table 6]**

| | | Preparation Example | | | |
|---|---|---|---|---|---|
| | | BG5 | BG6 | BG7 | BG8 |
| Resin | A-3 | 73.0 | 61.6 | 59.0 | 47.6 |
| Quantum dots | BG-1 | 20 | | 40 | |
| | BG-2 | | 20 | | 40 |
| Photo-acid generator | F-1 | 7 | 3 | 1 | 0.5 |
| Epoxy crosslinking agent | G-1 | | 15.4 | | 11.9 |
| Solvent | PGMEA | 100 | 100 | 100 | 100 |

**[Table 7]**

| | | Preparation Example | | |
|---|---|---|---|---|
| | | A'1 | A'2 | A'3 |
| Resin | A-1 | 82.8 | 91.8 | |
| | A-2 | | | 93.8 |
| Dye | B' - 1 | 10 | | |
| | B' - 2 | | 5 | |
| | B' - 3 | | | 5 |
| Photo-radical generator | C-1 | 7 | 3 | 1 |
| Surfactant | D-1 | 0.2 | 0.2 | 0.2 |
| Solvent | PGMEA | 100 | 100 | 100 |

In Tables 1 to 7, A-1 is "RA-4101" (trade name) (Mw: 30,000, acid value: 90 mg KOH/g, double bond equivalent: 350 g/mol) manufactured by Negami Chemical Industrial Co., Ltd., and A-2 is "8KQ-2001" (trade name) (Mw: 20,000, acid value: 130 mg KOH/g, double bond equivalent: 540 g/mol) of Taisei Fine Chemical Co., Ltd.

In Tables 1 to 7, B-1 is FDB-002 (maximum absorption wavelength: 431 nm) manufactured by Yamada Chemical Co., Ltd., B-2 is FS Yellow 1017 (maximum absorption wavelength: 443 nm) manufactured by ARIMOTO CHEMICAL Co., Ltd., B-3 is FDB-005 (maximum absorption wavelength: 452 nm) manufactured by Yamada Chemical Co., Ltd., B-4 is FDB-006 (maximum absorption wavelength: 473 nm) manufactured by Yamada Chemical Co., Ltd., B'-1 is FDB-009 (maximum absorption wavelength: 402 nm) manufactured by Yamada Chemical Co., Ltd., B'-2 is FDG-001 (maximum absorption wavelength: 503 nm) manufactured by Yamada Chemical Co., Ltd., and B'-3 is FDR-001 (maximum absorption wavelength: 604 nm) manufactured by Yamada Chemical Co., Ltd.

In Tables 1 to 7, BR-1 is S-BE030 (InP (core)/ZnS and ZnSe (shell), maximum fluorescence wavelength: 635 nm) manufactured by SHOEI CHEMICAL INC., BG-1 is S-BE029 (InP (core) /ZnS and ZnSe (shell), maximum fluorescence wavelength: 535 nm), BR-2 is 900514-1ML (CdSe (core)/CdS (shell), maximum fluorescence wavelength: 620 nm) manufactured by Aldrich, and BG-2 is 900511-1ML (CdSe (core) /CdS (shell), maximum fluorescence wavelength: 530 nm) manufactured by Aldrich. Note that the particle size of the quantum dots is 5 to 10 nm for red and 3 to 5 nm for green.

In Tables 1 to 7, C-1 is "Irgacure OXE01" (trade name) (oxime ester-based) manufactured by BASF Corporation.

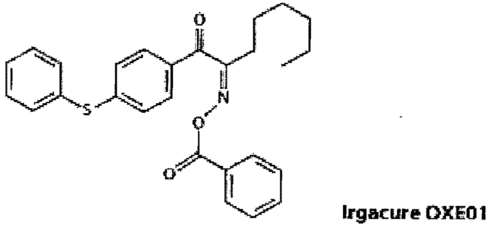

In Tables 1 to 7, D-1 is "KP341" (trade name) (polyether-type silicone-based surfactant) manufactured by Shin-Etsu Chemical Co., Ltd.

As A-3 in Tables 1 to 7, a material synthesized in the following manner was used. Into a 3-L flask equipped with a stirrer, a thermometer, a nitrogen inflow instrument, and a reflux condenser, 265.0 g (1.00 mol) of the following Compound (S-5) was introduced. Then, 2,000 g of toluene was added thereto, and the mixture was heated to 70°C. Subsequently, 1.0 g of a solution of chloroplatinic acid in toluene (platinum concentration: 0.5 mass%) was introduced, and 164.9 g (0.85 mol) of the following Compound (S-1) and 453.0 g (0.15 mol) of the following Compound (S-2) (y¹=40, manufactured by Shin-Etsu Chemical Co., Ltd.) were added dropwise over 1 hour (total of hydrosilyl groups/total of alkenyl groups=1/1 (molar ratio)). After completion of the dropwise addition, the mixture was heated to 100°C and aged for 6 hours. Thereafter, toluene was evaporated from the reaction solution under reduced pressure. Thus, Resin A-3 with an Mw of 65,000 was obtained.

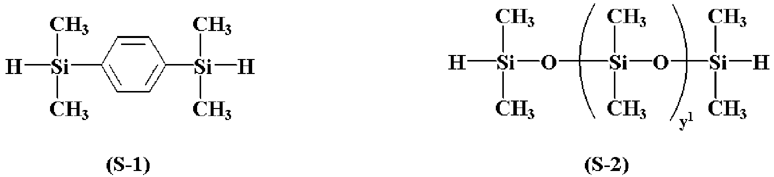

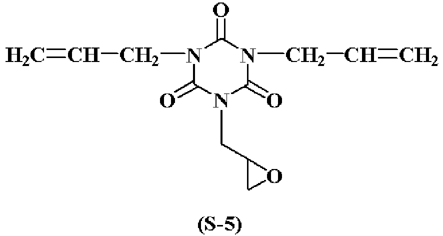

As the Photo-Acid Generator F-1 in Tables 1 to 7, "CPI-210S" (trade name) of San-Apro Ltd. was used.

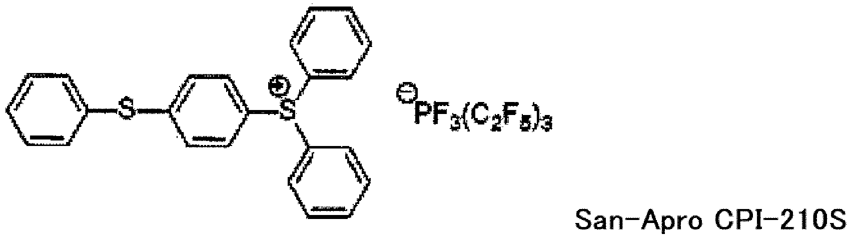

In Tables 1 to 7, the Epoxy Crosslinking Agent G-1 is as follows.

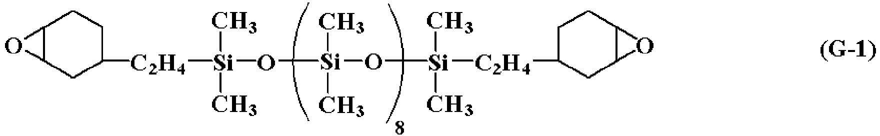

### [2] Preparation of Photosensitive Resin Film Layer (A) and Transmittance at Each Wavelength

Using a die coater as a film coater, each of the photosensitive resin compositions (A) (A1 to A8 and A'1 to A'3) shown in Tables 1, 2, and 7 was applied onto a support film which was a polyethylene terephthalate film (thickness: 38 µm). Then, the resultant was dried by passing, for 5 minutes, through a hot-air circulating oven (length: 4 m) set at 80°C. Thereby, a photosensitive resin film was formed on the support film to have a thickness of 3 µm, and a photosensitive resin film layer (A) was obtained. Onto the photosensitive resin film, a polyethylene film (thickness: 50 µm) as a protective film was bonded using a laminate roll at a pressure of 1 MPa. In this manner, a photosensitive dry film with a protective film was prepared. The protective film was peeled from the photosensitive dry film with a protective film, and the photosensitive resin film on the support film was respectively brought into close contact with a glass wafer by using a vacuum laminator TEAM-100RF (manufactured by Takatori Corporation) with the degree of vacuum in the vacuum chamber set to 80 Pa. The temperature condition was set to 100°C. The pressure was restored to normal pressure, then the substrate was taken out of the vacuum laminator, and the support film was peeled. Subsequently, using a spectrophotometer U-3900H (manufactured by Hitachi High-Tech Corporation), the transmittance of the cured film was measured in 450 to 470 nm, 515 to 535 nm, and 620 to 640 nm. When the cured film satisfied a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, the evaluation "Good" was given, and when the cured film did not satisfy these conditions, the evaluation "Bad" was given. The results are shown in Table 8.

Note that, in the transmittance measurement, A1 to A8 had a transmittance of 2% or less in 450 to 470 nm, a transmittance of 80% or more in 515 to 535 nm, and a transmittance of 80% or more in 620 to 640 nm.

**[Table 8]**

| | Preparation Example | | | | | | | | | | |
|---|---|---|---|---|---|---|---|---|---|---|---|
| | A1 | A2 | A3 | A4 | A5 | A6 | A7 | A8 | A'1 | A'2 | A'3 |
| Transmittance evaluation at each wavelength | Good | Good | Good | Good | Good | Good | Good | Good | Bad | Bad | Bad |

### [3] Preparation of Photosensitive Resin Film Layer (B)

Using a die coater as a film coater, each of the photosensitive resin compositions (B) shown in Tables 3 to 6 was applied onto a support film which was a polyethylene terephthalate film (thickness: 38 µm). Then, the resultant was dried by passing, for 5 minutes, through a hot-air circulating oven (length: 4 m) set at 80°C. Thereby, a photosensitive resin film was formed on the support film to have a thickness of 20 µm, and a photosensitive resin film layer (B) was obtained. Onto the photosensitive resin film, a polyethylene film (thickness: 50 µm) as a protective film was bonded using a laminate roll at a pressure of 1 MPa. In this manner, a photosensitive dry film with a protective film was prepared.

### [Examples 1 to 16 and Comparative Examples 1 to 22]

The protective films of the film provided with the photosensitive resin film layer (A) and the film provided with the photosensitive resin film layer (B) were peeled, and by using a roll to roll film laminator, the photosensitive resin film layer (A) and the photosensitive resin film layer (B) were bonded together to prepare multilayer-structure-type photosensitive dry films having the combinations shown in Table 9-1 to Table 11. The protective film of the prepared multilayer-structure-type photosensitive dry film on the side of the photosensitive resin film layer (B) was peeled. In this event, when it was visually observed that there was even one portion where the photosensitive resin film layer (B) had adhered to the protective film side, the evaluation "Bad" was given, and when there were no problems, the evaluation "Good" was given. The results are shown in Tables 9-1 to 11.

### [4] Pattern Formation and Evaluation Thereof

The protective film was peeled from the multilayer-structure-type photosensitive dry film with a protective film, and the side of the photosensitive resin film layer (B) on the support film was respectively brought into close contact with a glass wafer by using a vacuum laminator TEAM-100RF (manufactured by Takatori Corporation) with the degree of vacuum in the vacuum chamber set to 80 Pa. The temperature condition was set to 100°C. The pressure was restored to normal pressure, then the substrate was taken out of the vacuum laminator, and the support film was peeled. Subsequently, to enhance the adhesion to the substrate, pre-baking was performed with a hot plate at 100°C for 2 minutes. Exposure was performed using an i-line stepper NSR-2205i11D (manufactured by Nikon Corporation) to form a square island pattern on the obtained photosensitive resin film layers (A) and (B) via a mask in such a manner as to achieve a pitch width of 1:1 between adjacent patterns. After irradiation, spray development was performed with PGMEA for 20 seconds to form a pattern. After that, the formed 50-µm, 30-µm, 20-µm, and 10-µm square island patterns were observed with a scanning electron microscope (SEM), and the minimum pattern size at which adjacent island patterns (pitch width: 1:1) were not joined was obtained as the threshold resolution. The results are shown in Tables 9-1 to 11.

### [5] Chromaticity Measurement

In the same manner as above, a 4-cm square island pattern was formed on a glass wafer. After that, chromaticity measurement was performed from the front side by using an illuminance spectrophotometer MK350S PREMIUM (manufactured by UPRtek) while applying blue LED light from the reverse side of the substrate. The evaluation is "Red" when x ≥ 0.5 (red region), "Green" when y ≥ 0.5 (green region), and "Bad" in other cases. The results are shown in Tables 9-1 to 11.

**[Table 9-1]**

| | Example | | | | | | | |
|---|---|---|---|---|---|---|---|---|
| | 1 | 2 | 3 | 4 | 5 | 6 | 7 | 8 |
| Photosensitive resin film layer (A) | A1 | A2 | A3 | A4 | A5 | A6 | A7 | A8 |
| Photosensitive resin film layer (B) | BR1 | BR2 | BR3 | BR4 | BR5 | BR6 | BR7 | BR8 |
| Dry film cover film peeling property | Good | Good | Good | Good | Good | Good | Good | Good |
| Threshold resolution/µm | 20 | 20 | 20 | 20 | 20 | 20 | 20 | 20 |
| Chromaticity measurement | Red | Red | Red | Red | Red | Red | Red | Red |

**[Table 9-2]**

| | Example | | | | | | | |
|---|---|---|---|---|---|---|---|---|
| | 9 | 10 | 11 | 12 | 13 | 14 | 15 | 16 |
| Photosensitive resin film layer (A) | A1 | A2 | A3 | A4 | A5 | A6 | A7 | A8 |
| Photosensitive resin film layer (B) | BG1 | BG2 | BG3 | BG4 | BG5 | BG6 | BG7 | BG8 |
| Dry film cover film peeling property | Good | Good | Good | Good | Good | Good | Good | Good |
| Threshold resolution/µm | 20 | 20 | 20 | 20 | 20 | 20 | 20 | 20 |
| Chromaticity measurement | Green | Green | Green | Green | Green | Green | Green | Green |

**[Table 10-1]**

| | Comparative Example | | | | | | | |
|---|---|---|---|---|---|---|---|---|
| | 1 | 2 | 3 | 4 | 5 | 6 | 7 | 8 |
| Photosensitive resin film layer (A) | - | - | - | - | - | - | - | - |
| Photosensitive resin film layer (B) | BR1 | BR2 | BR3 | BR4 | BR5 | BR6 | BR7 | BR8 |
| Dry film cover film peeling property | - | - | - | - | - | - | - | - |
| Threshold resolution/µm | 30 | 30 | 30 | 30 | 30 | 30 | 30 | 30 |
| Chromaticity measurement | Bad | Bad | Bad | Bad | Bad | Bad | Bad | Bad |

**[Table 10-2]**

| | Comparative Example | | | | | | | |
|---|---|---|---|---|---|---|---|---|
| | 9 | 10 | 11 | 12 | 13 | 14 | 15 | 16 |
| Photosensitive resin film layer (A) | - | - | - | - | - | - | - | - |
| Photosensitive resin film layer (B) | BG1 | BG2 | BG3 | BG4 | BG5 | BG6 | BG7 | BG8 |
| Dry film cover film peeling property | - | - | - | - | - | - | - | - |
| Threshold resolution/µm | 30 | 30 | 30 | 30 | 30 | 30 | 30 | 30 |
| Chromaticity measurement | Bad | Bad | Bad | Bad | Bad | Bad | Bad | Bad |

**[Table 11]**

| | Comparative Example | | | | | |
|---|---|---|---|---|---|---|
| | 17 | 18 | 19 | 20 | 21 | 22 |
| Photosensitive resin film layer (A) | A'1 | A'2 | A'3 | A'1 | A'2 | A'3 |
| Photosensitive resin film layer (B) | BR1 | BR2 | BR3 | BG1 | BG2 | BG3 |
| Dry film cover film peeling property | Bad | Bad | Bad | Bad | Bad | Bad |
| Threshold resolution/µm | Bad | 50 | 50 | Bad | 50 | 50 |
| Chromaticity measurement | Bad | Bad | Bad | Bad | Bad | Bad |

As shown in Tables 9-1 and 9-2, in Examples 1 to 16, being inventive multilayer-structure-type photosensitive dry films, a photosensitive resin film layer (A), having a predetermined light transmittance, and a photosensitive resin film layer (B), containing quantum dots, are bonded together, and therefore, the process can be performed at once. Furthermore, cover film peeling property, threshold resolution, and chromaticity measurement were all favorable. On the other hand, as shown in Tables 10-1 and 10-2, the photosensitive dry films of Comparative Examples 1 to 16 do not have a photosensitive resin film layer (A), and only have a photosensitive resin film layer (B), and therefore, the process cannot be performed at once. Meanwhile, as shown in Tables 11 and 8, in Comparative Examples 17 to 22, the transmittance of the photosensitive resin film layer (A) at each wavelength was outside the range of the present invention, and therefore, it was not possible to eliminate blue light with high precision, so that the results of the chromaticity measurement was poor.

From the above results, the inventive multilayer-structure-type photosensitive dry film has no problems in the peeling property of the protective film, is efficient, since it is possible to perform a process for a photoresist containing quantum dots and a process for a resist material that absorbs blue LED light at once and not separately, and also makes it possible to form a fine pattern easily. In addition, an obtained cured film allows favorable hue conversion of blue LED light, and therefore, can be used suitably for displays such as micro-LED displays.

The present description includes the following inventions.
[1]: A multilayer-structure-type photosensitive dry film comprising:
   a support film;
   a photosensitive resin film layer (A) having a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, and having a film thickness of 1 to 10 µm on the support film; and
   a photosensitive resin film layer (B) containing quantum dots and having a film thickness of 1 to 100 µm on the photosensitive resin film layer (A).
[2]: The multilayer-structure-type photosensitive dry film according to [1], wherein the photosensitive resin film layer (A) contains 0.5 to 15 mass% of a dye having a maximum absorption wavelength at any wavelength of 490 to 430 nm.
[3]: The multilayer-structure-type photosensitive dry film according to [1] or [2], wherein the photosensitive resin film layer (B) contains 15 to 45 mass% of the quantum dots.
[4]: The multilayer-structure-type photosensitive dry film according to any one of [1] to [3], wherein the quantum dots each have a core-shell structure including a core and a shell covering the core, the core containing one or more compounds including a combination of two or more of In, P, Zn, Ga, Cd, Se, S, Te, Pb, Ag, Hg, N, As, and O, and the shell containing one or more compounds including a combination of two or more of In, P, Zn, Ga, Cd, Se, S, Te, Pb, Hg, N, As, O, Mn, and Sr.
[5]: The multilayer-structure-type photosensitive dry film according to any one of [1] to [4], wherein one or both of the photosensitive resin film layer (A) and the photosensitive resin film layer (B) contain, as a resin component, an acrylic resin having a (meth)acryloyl group in a side chain.
[6]: The multilayer-structure-type photosensitive dry film according to any one of [1] to [4], wherein one or both of the photosensitive resin film layer (A) and the photosensitive resin film layer (B) contain, as a resin component, a resin having a silicone skeleton and a silphenylene skeleton.
[7]: A patterning process comprising the steps of:
   (i) bonding a side of the photosensitive resin film layer (B) of the multilayer-structure-type photosensitive dry film according to any one of [1] to [6] to a substrate to form a photosensitive resin film on the substrate;
   (ii) exposing the photosensitive resin film to light; and
   (iii) developing the exposed photosensitive resin film with a developer to dissolve and remove an unexposed portion to form a pattern.
[8]: A display comprising a pattern formed of a cured film of the photosensitive resin film layer (A) and the photosensitive resin film layer (B) of the multilayer-structure-type photosensitive dry film according to any one of [1] to [6].
[9]: A display comprising, in a top portion of a blue LED, a pattern formed of a cured film of the photosensitive resin film layer (A) and the photosensitive resin film layer (B) of the multilayer-structure-type photosensitive dry film according to any one of [1] to [6], light color-converted by quantum dots being obtained from each subpixel.
[10]: A micro-LED display comprising, in a top portion of a blue LED, a pattern formed of a cured film of the photosensitive resin film layer (A) and the photosensitive resin film layer (B) of the multilayer-structure-type photosensitive dry film according to any one of [1] to [6], the pattern formed of the cured film having a size of 0.01 mm² or less, and light color-converted by quantum dots being obtained from each subpixel.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A multilayer-structure-type photosensitive dry film comprising:
a support film;
a photosensitive resin film layer (A) having a transmittance of 2% or less in at least part of wavelengths of 450 to 470 nm, a transmittance of 80% or more in at least part of wavelengths of 515 to 535 nm, and a transmittance of 80% or more in at least part of wavelengths of 620 to 640 nm, and having a film thickness of 1 to 10 µm on the support film; and
a photosensitive resin film layer (B) containing quantum dots and having a film thickness of 1 to 100 µm on the photosensitive resin film layer (A).

2. The multilayer-structure-type photosensitive dry film according to claim 1, wherein the photosensitive resin film layer (A) contains 0.5 to 15 mass% of a dye having a maximum absorption wavelength at any wavelength of 490 to 430 nm.

3. The multilayer-structure-type photosensitive dry film according to claim 1, wherein the photosensitive resin film layer (B) contains 15 to 45 mass% of the quantum dots.

4. The multilayer-structure-type photosensitive dry film according to claim 1, wherein the quantum dots each have a core-shell structure including a core and a shell covering the core, the core containing one or more compounds including a combination of two or more of In, P, Zn, Ga, Cd, Se, S, Te, Pb, Ag, Hg, N, As, and O, and the shell containing one or more compounds including a combination of two or more of In, P, Zn, Ga, Cd, Se, S, Te, Pb, Hg, N, As, O, Mn, and Sr.

5. The multilayer-structure-type photosensitive dry film according to claim 1, wherein one or both of the photosensitive resin film layer (A) and the photosensitive resin film layer (B) contain, as a resin component, an acrylic resin having a (meth)acryloyl group in a side chain.

6. The multilayer-structure-type photosensitive dry film according to claim 1, wherein one or both of the photosensitive resin film layer (A) and the photosensitive resin film layer (B) contain, as a resin component, a resin having a silicone skeleton and a silphenylene skeleton.

7. A patterning process comprising the steps of:
(i) bonding a side of the photosensitive resin film layer (B) of the multilayer-structure-type photosensitive dry film according to any one of claims 1 to 6 to a substrate to form a photosensitive resin film on the substrate;
(ii) exposing the photosensitive resin film to light; and
(iii) developing the exposed photosensitive resin film with a developer to dissolve and remove an unexposed portion to form a pattern.

8. A display comprising a pattern formed of a cured film of the photosensitive resin film layer (A) and the photosensitive resin film layer (B) of the multilayer-structure-type photosensitive dry film according to any one of claims 1 to 6.

9. A display comprising, in a top portion of a blue LED, a pattern formed of a cured film of the photosensitive resin film layer (A) and the photosensitive resin film layer (B) of the multilayer-structure-type photosensitive dry film according to any one of claims 1 to 6, light color-converted by quantum dots being obtained from each subpixel.

10. A micro-LED display comprising, in a top portion of a blue LED, a pattern formed of a cured film of the photosensitive resin film layer (A) and the photosensitive resin film layer (B) of the multilayer-structure-type photosensitive dry film according to any one of claims 1 to 6, the pattern formed of the cured film having a size of 0.01 mm² or less, and light color-converted by quantum dots being obtained from each subpixel.
